# EUROPEAN PATENT APPLICATION

(11) **EP 1 873 825 A2**
(43) Date of publication of application: **02.01.2008**
(21) Application number: 07111023.3
(22) Date of filing: 26.06.2007
(51) Int. Cl.: H01L 21/78, H01L 33/00

(54) **Semiconductor device, LED head and image forming apparatus**

(30) Priority: 28.06.2006 JP 2006178349
(71) Applicant: Oki Data Corporation, Tokyo 108-8551 (JP)
(72) Inventor: Furuta, Hironori c/o Oki Digital Imaging Corporation, Tokyo 193-8550 (JP); Ogihara, Mitsuhiko c/o Oki Digital Imaging Corporation, Tokyo 193-8550 (JP); Fujiwara, Hiroyuki c/o Oki Digital Imaging Corporation, Tokyo 193-8550 (JP); Igari, Tomoki c/o Oki Digital Imaging Corporation, Tokyo 193-8550 (JP); Muto, Masataka c/o Oki Digital Imaging Corporation, Tokyo 193-8550 (JP)
(74) Representative: Pisani, Diana Jean

(57) **Abstract**

A semiconductor device is manufactured using dicing of a semiconductor wafer. The semiconductor device includes a substrate (10), a base insulating layer (11) formed on the substrate, a semiconductor element (20) formed on the base insulating layer, and a separate pattern portion (15) formed on an end portion of the substrate separately from the base insulating layer. The separate pattern portion prevents the base insulating layer from being peeled off from the substrate when the dicing is performed.

## Description

### BACKGROUND OF THE INVENTION

This invention relates to a semiconductor device used as an LED (Light-emitting Diode) array or the like, and also relates to an LED head and an image forming apparatus including the LED array.

An electrophotographic image forming apparatus uses an LED head including combined LED array chips and driver chips. The LED array chip includes an array of LEDs, and the driver chip includes driving circuits.

In order to achieve high resolution, the image forming apparatus of this type employs an LED head including a semiconductor substrate on which a plurality of LED array chips and a plurality of driver chips are mounted.

In order to reduce the number of chips to be mounted, there is proposed a semiconductor device having a configuration where semiconductor thin films (in which LED elements are previously formed) are bonded onto a semiconductor substrate on which driving circuits are formed. The LED elements and the driving circuits are electrically connected using an interconnection pattern. Such a semiconductor device is disclosed in, for example, Japanese Laid-Open Patent Publication No. 2004-179641.

The semiconductor device of this type is manufactured by bonding a plurality of semiconductor thin films onto a base insulating layer formed on a semiconductor wafer, and by dicing the semiconductor wafer.

However, when the semiconductor wafer is diced in the manufacturing of the semiconductor device as described above, a dicing saw may apply a large external force to the base insulating layer at a cutting position. Therefore, the base insulating layer or an insulating film or a metal film of layered films (such as a multilayer interconnection or the like formed on the semiconductor substrate in the vicinity of the cutting position) may be peeled off from the semiconductor substrate, and may be fractured. Moreover, in accordance with the peeling of the base insulating layer and any one of the layered films in the vicinity of the cutting position, there is a possibility that the semiconductor thin films may be peeled off from the base insulating layer.

### SUMMARY OF THE INVENTION

An object of the present invention is to provide a semiconductor device capable of preventing the peeling of a base insulating layer, and to provide an LED head and an image forming apparatus using the semiconductor device.

The present invention provides a semiconductor device manufactured using dicing of a semiconductor wafer. The semiconductor device includes a substrate, a base insulating layer formed on the substrate, a semiconductor element formed on the base insulating layer, and a separate pattern portion formed on an end portion of the substrate separately from the base insulating layer. The separate pattern portion prevents the base insulating layer from being peeled off from the substrate when the dicing is performed.

The present invention also provides a semiconductor device manufactured using dicing of a semiconductor wafer. The semiconductor device includes a substrate, a base insulating layer formed on the substrate, a semiconductor element formed on the base insulating layer, and a peeling-preventing pattern portion that holds an end portion of the base insulating layer at an end portion of the substrate.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

In the attached drawings:
FIG. 1 is a plan view showing a main part of a semiconductor device according to Embodiment 1 of the present invention;
FIG. 2 is a sectional view showing the semiconductor device according to Embodiment 1, taken along line II-II shown in FIG. 1;
FIG. 3 is a sectional view showing a light-emitting portion of the semiconductor device according to Embodiment 1, taken along line III-III shown in FIG. 1;
FIG. 4 is a sectional view showing a semiconductor thin film of the semiconductor device according to Embodiment 1, taken along line IV-IV shown in FIG. 1;
FIG. 5 is a plan view showing a fracture of the semiconductor device according to Embodiment 1 that occurs in a dicing process;
FIGS. 6A and 6B are plan views showing a first modification of Embodiment 1 and a variation thereof;
FIG. 7 is a plan view showing a second modification of Embodiment 1;
FIG. 8 is a plan view showing a third modification of Embodiment 1;
FIG. 9 is a plan view showing a fourth modification of Embodiment 1;
FIG. 10 is a plan view showing a fifth modification of Embodiment 1;
FIG. 11 is a plan view showing a sixth modification of Embodiment 1;
FIG. 12 is a plan view showing a seventh modification of Embodiment 1;
FIG. 13 is a sectional view showing a first modification of the light-emitting portion of the semiconductor device of Embodiment 1;
FIG. 14 is a sectional view showing a second modification of the light-emitting portion of the semiconductor device of Embodiment 1;
FIG. 15 is a sectional view showing a third modification of the light-emitting portion of the semiconductor device of Embodiment 1;
FIG. 16 is a sectional view showing a fourth modification of the light-emitting portion of the semiconductor device of Embodiment 1;
FIG. 17 is a plan view showing another modification of Embodiment 1;
FIG. 18 is a plan view showing a semiconductor device according to Embodiment 2 of the present invention;
FIG. 19 is a sectional view showing the semiconductor device according to Embodiment 2, taken along line XIX-XIX shown in FIG. 18;
FIG. 20 is a plan view showing a fracture of the semiconductor device according to Embodiment 2 that occurs in a dicing process;
FIG. 21 is a plan views showing a first modification of Embodiment 2;
FIG. 22 is a plan view showing a second modification of Embodiment 2;
FIG. 23 is a plan view showing a third modification of Embodiment 2;
FIG. 24 is a plan view showing a fourth modification of Embodiment 2;
FIG. 25 is a sectional view showing an LED print head as an LED head of Embodiment 3 of the present invention;
FIG. 26 is a plan view showing an arrangement of the configuration example of the LED head of FIG. 25;
FIG. 27 shows a configuration of a main part of an image forming apparatus according to Embodiment 4 of the present invention;
FIG. 28 is a plan view showing a semiconductor device according to Embodiment 5 of the present invention;
FIG. 29 is a sectional view of the semiconductor device of Embodiment 5 taken along line XXIX-XXIX of FIG. 28;
FIG. 30 is a sectional view of the semiconductor device of Embodiment 5 taken along line XXX-XXX of FIG. 28;
FIG. 31 is a plan view showing a first modification of Embodiment 5;
FIG. 32 is a plan view showing a second modification of Embodiment 5, and
FIG. 33 is a plan view showing a third modification of Embodiment 5.

### DETAILED DESCRIPTION OF THE PREFERRED EMBODIMENT

Embodiments of the present invention will be described with reference to the attached drawings.

### Embodiment 1.

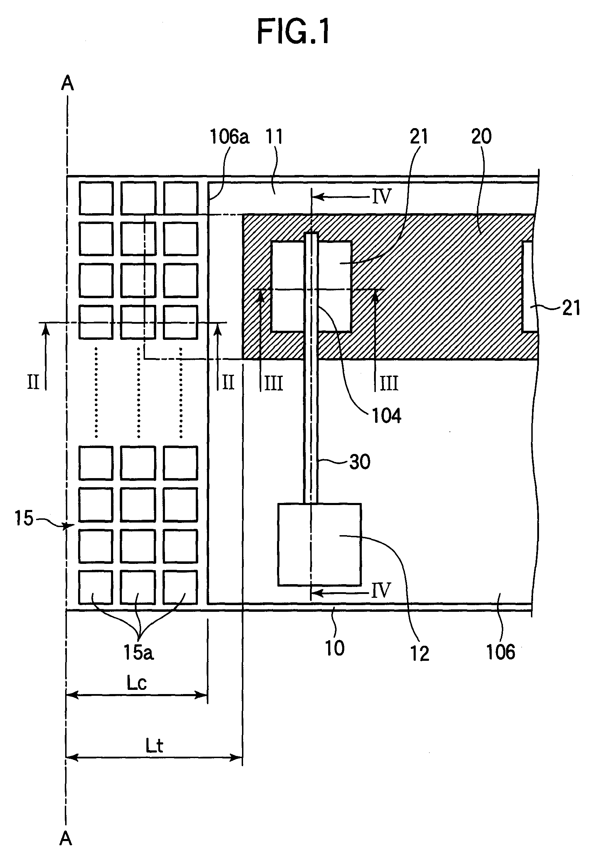

FIG. 1 is a plan view showing a main part of a semiconductor device according to Embodiment 1 of the present invention.

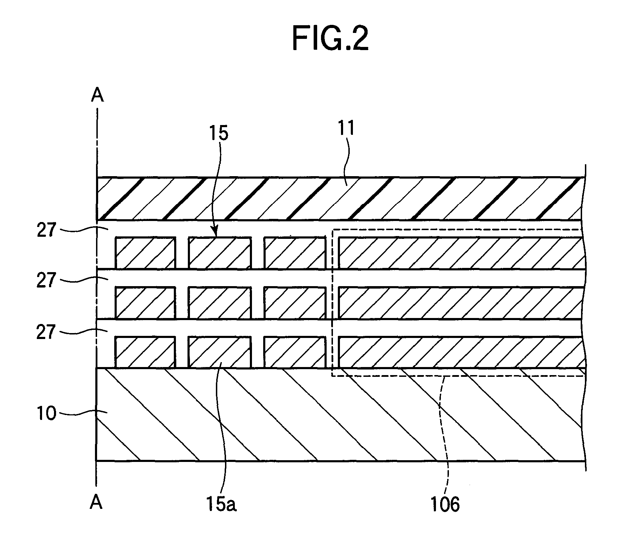

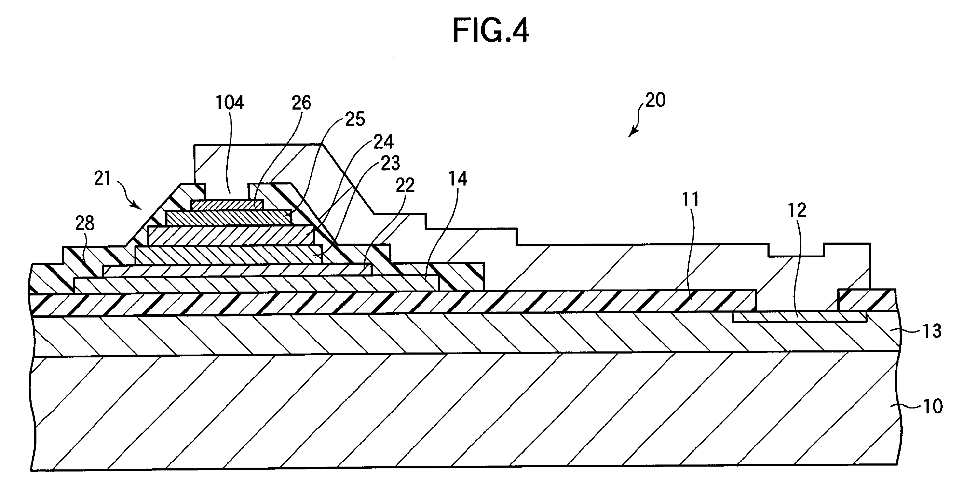

The semiconductor device according to Embodiment 1 includes a semiconductor substrate 10 (for example, Si substrate) on which an integrated circuit region 106 is formed. Insulating films (not shown in FIG. 1) of SiN or the like are formed on the integrated circuit region 106. As the top layer of the insulating films, a base insulating layer 11 (FIG. 2) for a semiconductor thin film 20 is formed. The base insulating layer 11 is formed of an inorganic insulating film such as SiN, SIO₂ and Al₂O₃ or an organic insulating film such as polyimide. A semiconductor thin film 20 is directly bonded by means of intermolecular force onto the base insulating layer 11 or a conducting layer 14 (FIG. 4, described later) provided on the base insulating layer 11. The semiconductor thin film 20 includes, for example, a light-emitting portion 21 as an LED. A conductive contact 104 of the second conductivity type (for example, p-type) is formed on the light-emitting portion 21. The p-type conductive contact 104 leads to a connection pad 12 provided on the integrated circuit region via an interconnection line 30.

FIG. 2 is a sectional view taken along line II-II of FIG. 1. As shown in FIG. 2, the semiconductor device according to Embodiment 1 has a multilayer structure including, for example, three layers. The number of the layers of the semiconductor device is the same as, for example, the number of layers of a multilayer interconnection that constitutes the integrated circuit region 106. Each of the layers of the semiconductor device is composed of a separate pattern portion 15 and an interlayer insulating layer 27 covering the separate pattern portion 15. Further, the base insulating layer 11 is formed on the interlayer insulating layer 27. In the semiconductor device shown in FIG. 2, the separate pattern portion 15 on the semiconductor substrate 10 includes three layers. In each layer, the separate pattern portion 15 is covered by the interlayer insulating layer 27.

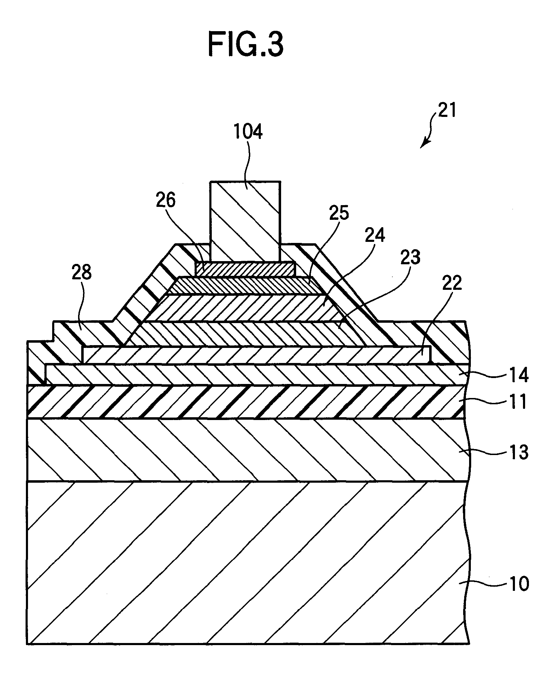

FIG. 3 is a sectional view of the light-emitting portion 21 of the semiconductor device according to Embodiment 1, taken along line III-III of FIG. 1. FIG. 4 is a sectional view of the semiconductor thin film 20 of the semiconductor device according to Embodiment 1, taken along line IV-IV of FIG. 1.

As shown in FIGS. 3 and 4, a multilayer interconnection region 13 of a driving circuit is provided on the semiconductor substrate 10. The base insulating layer 11 is formed to cover the multilayer interconnection region 13. A light-emitting portion 21 is formed on the base insulating layer 11 via a conducting layer 14.

The light-emitting portion 21 has a layered structure of LED epitaxial layers. The light-emitting portion 21 includes an n-type contact layer 22 composed of n-type GaAs bonded onto the conducting layer 14, a lower cladding layer 23 composed of n-type Al_{z}Ga_{1-z}As formed on the n-type contact layer 22, an active layer 24 composed of n-type Al_{y}Ga_{1-y}As formed on the lower cladding layer 23, an upper cladding layer 25 composed of p-type AlₓGa₁₋ₓAs formed on the active layer 24, and a p-type contact layer 26 composed of p-type GaAs formed on the upper cladding layer 25. And end of the above described interconnection line 30 (FIG. 1) is connected to the p-type contact layer 26. Peripheral sides of the light-emitting portion 21 and the base insulating film 11 are covered by an insulating film 28.

Referring back to FIG. 1, the separate pattern portion 15 is formed on an end portion of a region which is to be formed into a chip (i.e., a region cut to become a chip in the dicing process). The separate pattern portion 15 is composed of a plurality of rectangular separate pattern segments 15a arranged in three lines. The separate pattern segments 15a are covered by the interlayer insulating layer 27, and are separated from the base insulating layer 11. The separate pattern segments 15a are formed of, for example, AlSiCu.

The semiconductor device is manufactured by dicing the semiconductor wafer. In FIG. 1, a line A-A indicates a dicing (cutting) line of Y-direction. The Y-direction is a direction perpendicular to the direction (X-direction) in which a plurality of light-emitting portions 21 are arranged. The dicing line A-A is apart from the end 106a of the integrated circuit region 106 by the distance Lc, and is apart from the closest end of the semiconductor thin film 20 by the distance Lt. In FIG. 1, the end of the semiconductor thin film 20 is located inside with respect to the end 106a of the integrated circuit region 106. However, there is a case where the end of the semiconductor thin film 20 is located outside with respect to the end 106a of the integrated circuit region 106 and located inside the separate pattern portion 15 as shown by a dashed-two dotted line in FIG. 1. As will be described later, in the case where a plurality of LED array chips are mounted in the print head, the pitch between the light-emitting portions located on the closest ends of the adjacent LED array chips is necessarily the same as the pitch of the light-emitting portions in each LED array chip. In contrast, the integrated circuit must be apart from the dicing line A-A as far as possible in order to enhance the reliability. Therefore, in the case of LED array chip, it is preferable that Lc < Lt is satisfied. Further, the shorter distance of the distances Lc and Lt is preferably greater than, at least, the width of one separate pattern segment 15a (i.e., a pattern element of the separate pattern portion 15). In other words, the width of one separate pattern segment 15a is preferably smaller than, at least, the shorter distance of the distances Lc and Lt.

For example, it is now assumed that a plurality of LED arrays (each including the light-emitting portions 21 arranged at constant pitch in the semiconductor thin film) are arranged at the pitch of 42.3 µm corresponding to 600 dpi (dots per inch). The thickness of the dicing saw is assumed to be 20 µm. The distance from the end of the light-emitting portion 21 to the end of the semiconductor thin film 20 is assumed to be 5 µm. In this case, the above described distance Lt is determined as follow: Lt = 42.3/2 - (20/2+5) = 6.15 (µm). Therefore, the width of one separate pattern segment 15a is preferably, at least, less than 6.15 (µm). Further, when the space of 1 µm is taken between the separate pattern segments 15a, the size (width) of the separate pattern segment 15a is preferably 6.15 - 1 = 5.15 (µm). By rounding off the decimals, it is preferable that the separate pattern segments 15a having the size of 5 µm are arranged in one vertical column (of the Y-direction) so that interspaces of 1 µm are formed between adjacent separate pattern segments 15a. With such an arrangement, when the interlayer insulating layer 27 or the base insulating layer 11 is peeled off in the dicing process, the separate pattern segments 15a may also be peeled off, but the peeling does not reach the films of the inner region (i.e., the semiconductor thin films 20 and the integrated circuit region 106) since the separate pattern segments 15a are formed independently. More preferably, when a plurality of separate pattern segments 15a and interspaces thereof are provided in the distance Lt or Lc, the effect of protecting the semiconductor thin films 20 and the integrated circuit region 106 can be further enhanced. Furthermore, when the size of the separate pattern segments 15a and the interspaces are reduced, the interlayer insulating layer 27 of the top layer can be flat. Moreover, the convexes and concaves of the surface of the interlayer insulating layer 27 can be further flattened by the base insulating layer 11, so that the semiconductor thin film 20 can be bonded onto the separate pattern region 15.

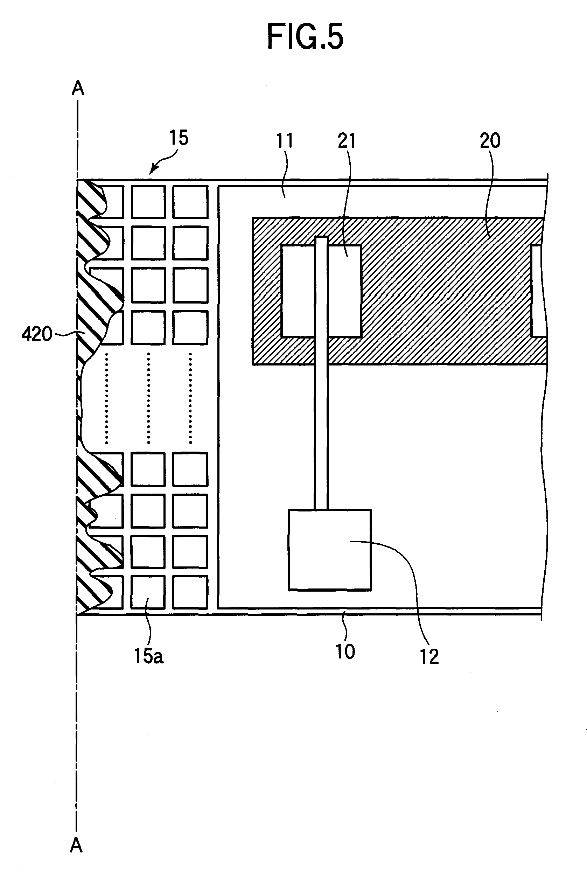

FIG. 5 is a plan view showing a fracture that occurs in the dicing process of the semiconductor device according to Embodiment 1. When the dicing is performed along the dicing line A-A shown in FIG. 5, an external force is applied by the dicing saw to the separate pattern segments 15a on an outermost column of the separate pattern portion 15 and parts of the interlayer insulating layer 27 formed thereon, and therefore the separate pattern segments 15a and the parts of the interlayer insulating layer 27 formed thereon are peeled off from the semiconductor substrate 10. However, the separate pattern segments 15a of the inner columns of the separate pattern portion 15 are provided separately from the separate pattern segments 15a of the outermost column, and therefore the external force applied by the dicing saw can be prevented from being transmitted widely. Therefore, the area where peeling occurs can be restricted. Accordingly, the external force is not applied to the base insulating layer 11 (formed separately from the separate pattern segments 15a), with the result that the peeling and the fracture of the base insulating layer 11 can be prevented. As a result, the peeling of the semiconductor thin film 20 does not occur.

The above described separate pattern portion 15 can be made by material(s) selected among, for example, AlSi, Al, Ni/Al, Ti, Ti/Pt/Au, Pd, Ca, Ti/W, Ni/Au and Ni/Pd. In this regard, a plurality of names of materials separated by a slash indicates a layered structure of the materials. For example, "Ti/Pt/Au" means a layered structure of layers of Ti, Pt and Au. Alternatively, the separate pattern portion 15 can be made of an insulating film such as SiO₂ film, PSG (phosphosilicate glass) film, BPS (back-surface polycrystalline silicon) film, SOG (spin-on-glass) film, SiN film, SiON film or the like.

As described above, according to Embodiment 1, the separate pattern portion 15 is formed on the end portion of the substrate 10 (i.e., in the vicinity of the dicing line A-A), and the separate pattern portion 15 has a width narrower than the distance from the dicing line A-A to the semiconductor thin film 20. Therefore, even when the base insulating layer 11 and the separate pattern portion 15 are peeled off from the semiconductor substrate 10 or fractured due to the force applied by the dicing saw, it is possible to prevent the spread of the peeling and fracture to the integrated circuit region 106, and it is also possible to prevent the semiconductor thin film 20 from being peeled off or fractured.

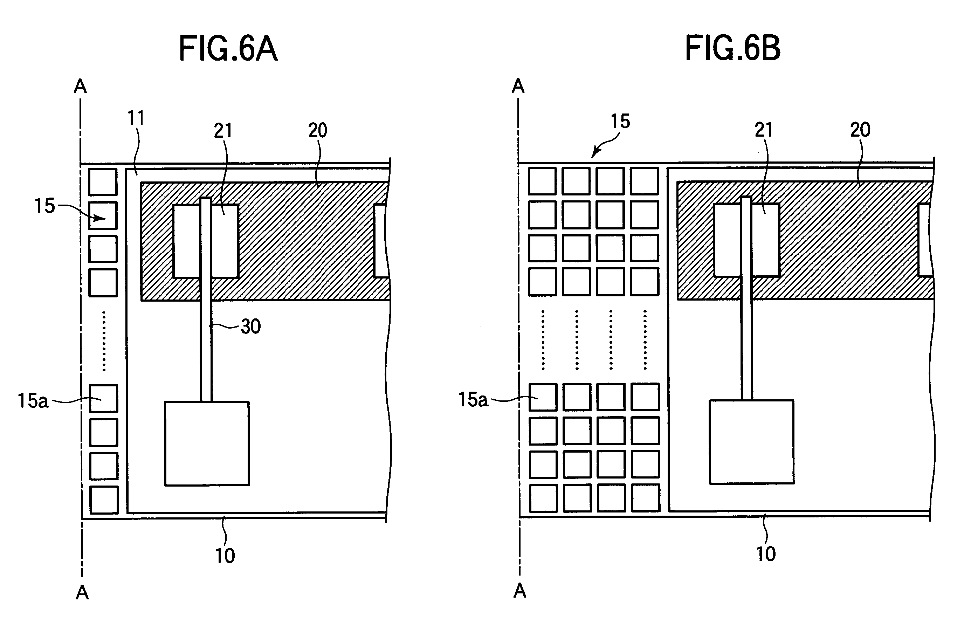

FIGS. 6A and 6B are plan views showing a first modification of Embodiment 1 and a variation thereof. In the modification shown in FIG. 6A, the separate pattern portion 15 includes the separate pattern segments 15a arranged in one column in the Y-direction on the end portion of the semiconductor substrate 10. In the variation shown in FIG. 6B, the separate pattern portion 15 includes the separate pattern segments 15a arranged in four columns in the Y-direction on the end portion of the semiconductor substrate 10.

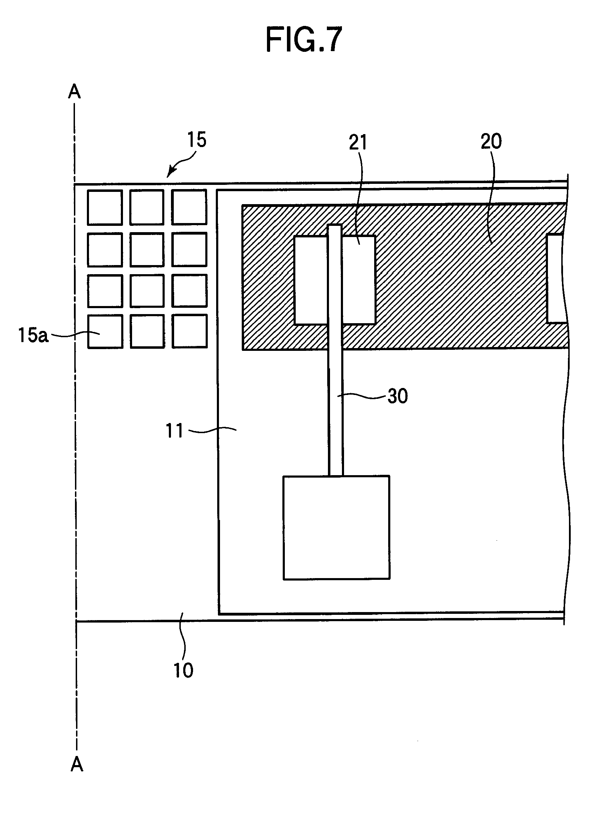

FIG. 7 is a plan view showing a second modification of Embodiment 1. In the modification shown in FIG. 7, the separate pattern portion 15 is provided at the corner of the semiconductor substrate 10 at which the dicing is started. By providing the separate pattern 15 at the corner of the semiconductor substrate 10 at which the dicing is started, it becomes possible to protect, at least, the semiconductor thin film 20. The modification shown in FIG. 7 is effective particularly when the semiconductor thin film 20 extends to a portion above the separate pattern portion 15 as shown by dashed-two dotted line of FIG. 1.

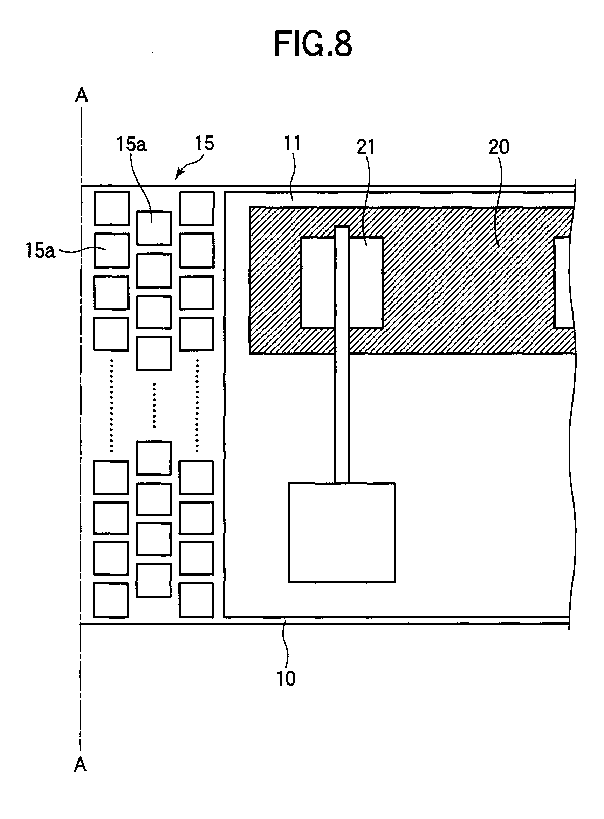

FIG. 8 is a plan view showing a third modification of Embodiment 1. In the modification shown in FIG. 8, the separate pattern portion 15 includes three columns of the separate pattern segments 15a arranged in a staggered manner.

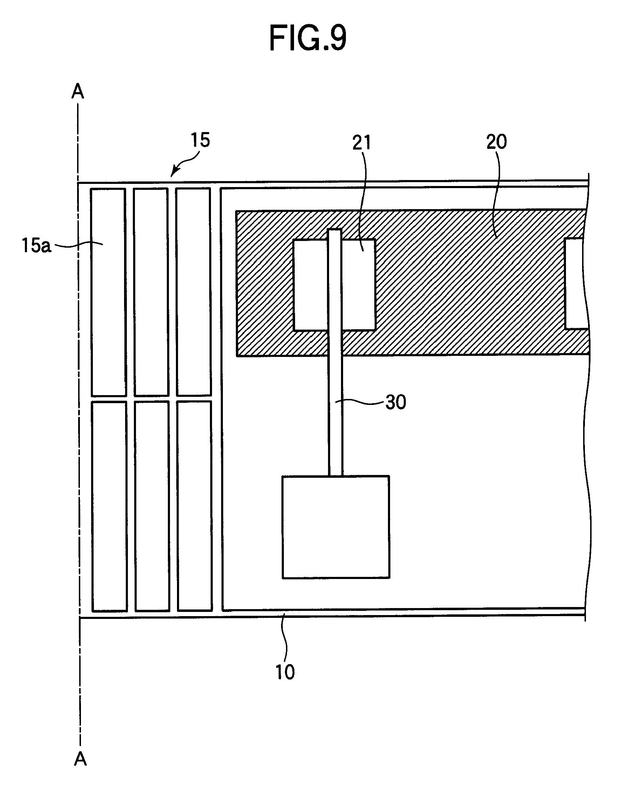

FIG. 9 is a plan view showing a fourth modification of Embodiment 1. In the modification shown in FIG. 9, the separate pattern portion 15 is so configured that each of the separate pattern segments 15a has an elongated rectangular shape having a narrower width (in the X-direction) and a longer length (in the Y-direction).

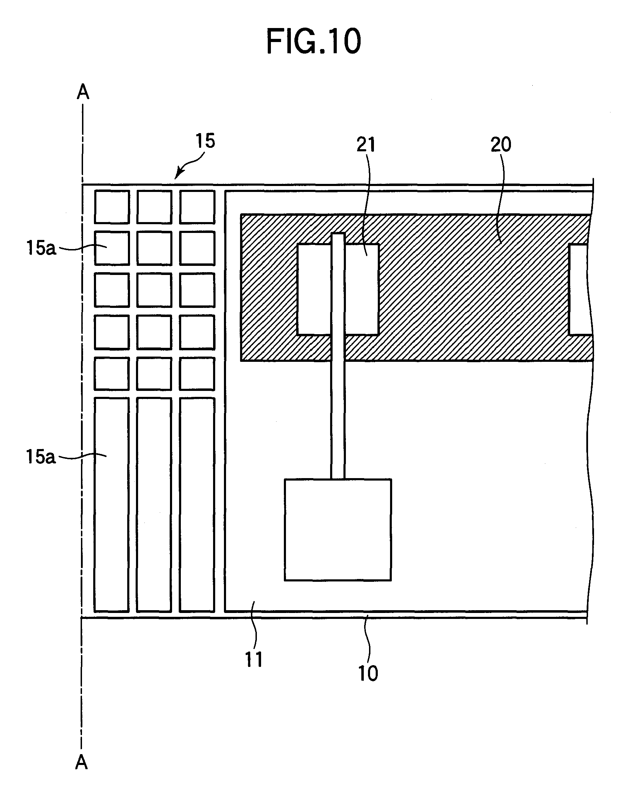

FIG. 10 is a plan view showing a fifth modification of Embodiment 1. In the modification shown in FIG. 10, the separate pattern portion 15 is so configured that each column of the separate pattern segments 15a includes a plurality of square separate pattern segments 15a and a plurality of elongated rectangular separate pattern segments 15a.

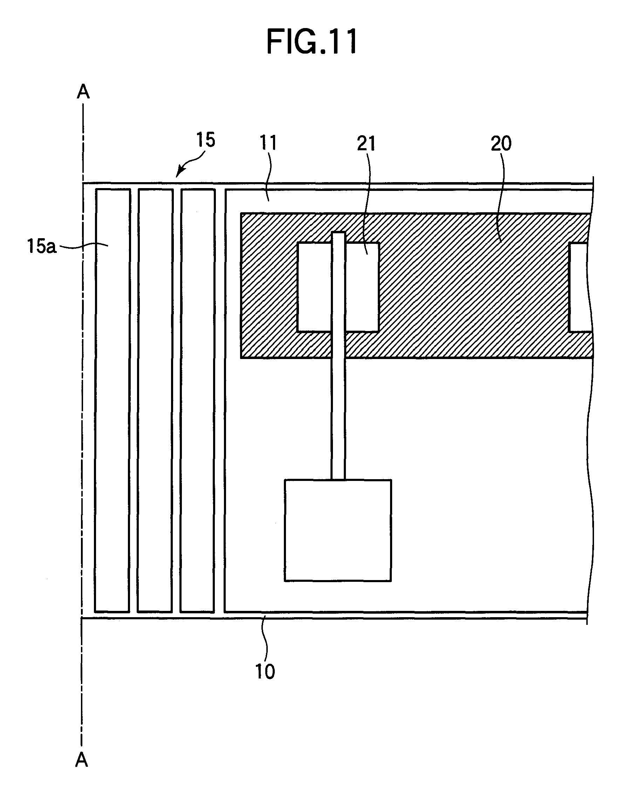

FIG. 11 is a plan view showing a sixth modification of Embodiment 1. In the modification shown in FIG. 11, the separate pattern portion 15 is so configured that each column of the separate pattern segments 15a includes one separate pattern segment 15a having the same length as the column.

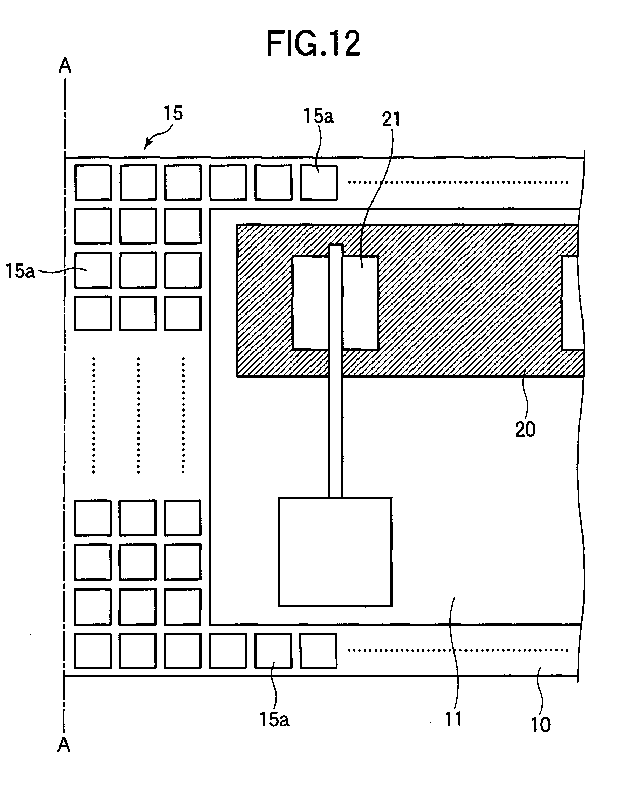

FIG. 12 is a plan view showing a seventh modification of Embodiment 1. In the modification shown in FIG. 12, the separate pattern portion 15 includes separate pattern segments 15a arranged on the respective end portions of four sides of the semiconductor substrate 10. In the case of the LED array chip, it is particularly difficult to lengthen the distance from the dicing line A-A to the end of the semiconductor thin film 20 (and also the end of the integrated circuit region 106 in some cases), which is the reason why the separate pattern portion 15 of Embodiment 1 is needed. When the separate pattern portions 15 are provided on four sides of the chip forming region as shown in FIG. 12, it becomes further possible to position the dicing line of the X-direction (the lateral direction) close to the end of the semiconductor thin film 20 (or the end of the integrated circuit region 106). Accordingly, the LED array chip having the narrow width in the Y-direction can be obtained.

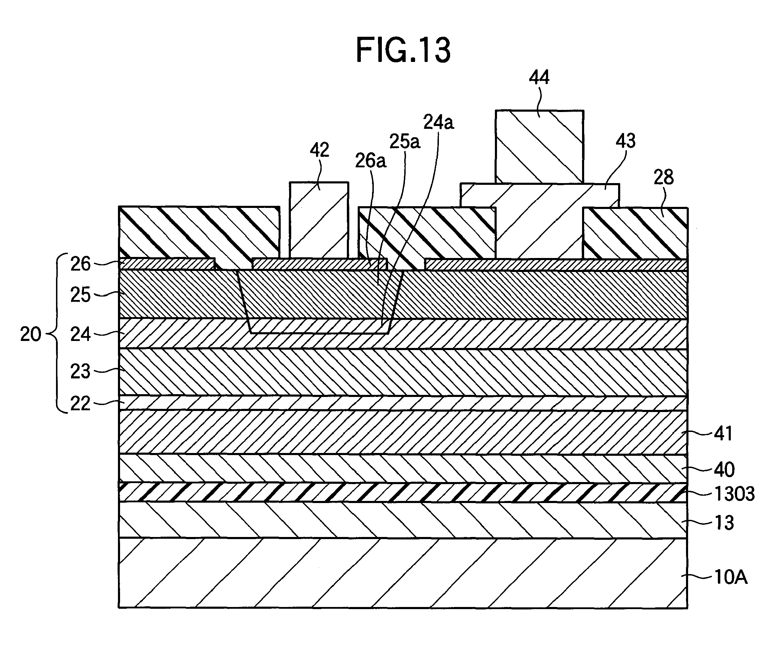

FIG. 13 is a sectional view showing a first modification of the light-emitting portion (FIG. 4) of the semiconductor device of Embodiment 1. The semiconductor device shown in FIG. 13 includes a Si substrate 10A, a multilayer interconnection region 13 of the driving circuit formed on the Si substrate 10A, a base insulating layer (i.e., a passivation film) 1303 for the integrated circuit wafer formed on the multilayer interconnection region 13, a reflective metal layer 40 formed on the base insulating layer 1303, and a flattening layer 41 (corresponding to the base insulating layer 11) formed on the reflective metal layer 40. A first conductivity region of the semiconductor thin film 20 includes a contact layer 22 composed of GaAs bonded onto the flattening layer 41, a lower cladding layer 23 composed of Al_{z}Ga_{1-z}As formed on the contact layer 22, an active layer 24 composed of Al_{y}Ga_{1-y}As formed on the lower cladding layer 23, and an upper cladding layer 25 composed of AlₓGa₁₋ₓAs formed on the active layer 24, and a contact layer 26 composed of GaAs formed on the upper cladding layer 25. A second conductivity region of the semiconductor thin film 20 includes diffusion regions 24a, 25a and 26a formed by selectively diffusing impurities of the second conductivity type into the active layer 24, the upper cladding layer 25 and the contact layer 26.

The semiconductor thin film 20 is covered by an insulating film 28. An electrode 42 of the second conductivity type is formed on the diffusion region 26a. An electrode 43 (for example, AuGe/Ni/Au) of the first conductivity type is formed on the contact layer 26 of the first conductivity type. An end of interconnection line 44 (for example, Ti/Pt/Au) is connected to the electrode 43.

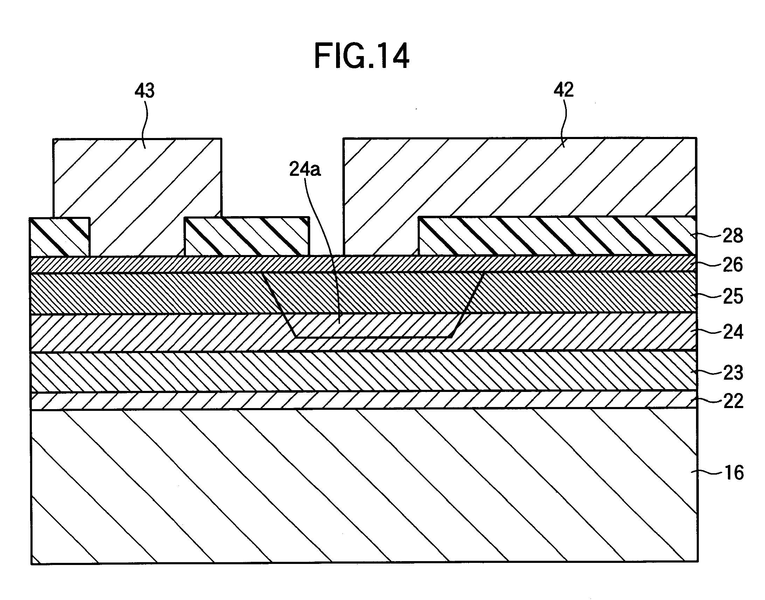

FIG. 14 is a sectional view showing a second modification of the light-emitting portion (FIG. 4) of the semiconductor device of Embodiment 1. In the modification shown in FIG. 14, the semiconductor layers of the first conductivity type (the layers 22 through 26 shown in FIG. 14) constituting an LED are epitaxially grown on a GaAs substrate 16, and impurities of the second conductivity type is selectively diffused into the semiconductor layers. The other configuration is the same as the semiconductor device shown in FIG. 13. Although not shown in FIG. 14, the light-emitting portion is connected to an integrated circuit region (for driving the LED) formed on other region on the GaAs substrate 16. In FIGS. 13 and 14, the contact layer can be replaced with a transparent electrode composed of ITO (Indium Tin Oxide), ZnO or the like.

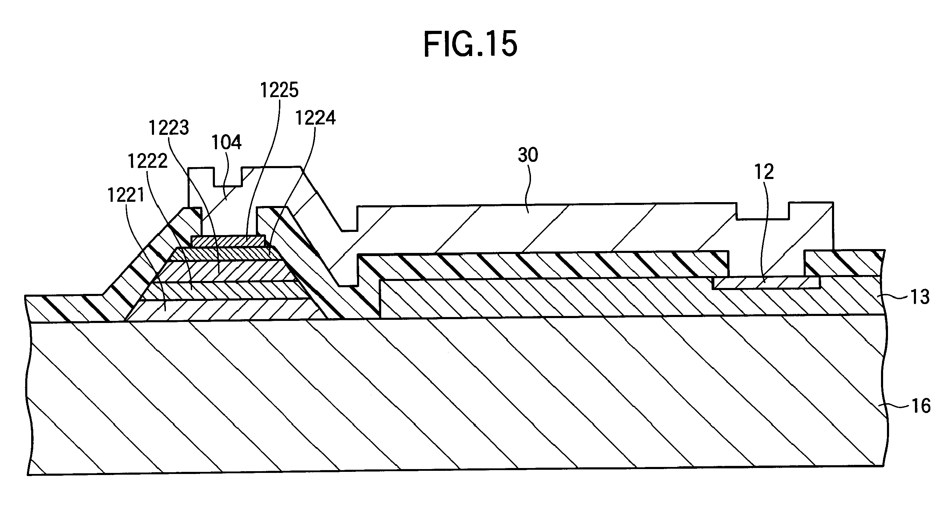

FIG. 15 is a sectional view showing a third modification of the light-emitting portion of the semiconductor device of Embodiment 1. In the above described example shown in FIG. 4, the semiconductor substrate thin film is formed on the integrated circuit formed on the Si substrate. In the semiconductor device shown in FIG. 15, a compound semiconductor substrate such as a GaAs substrate 16 is used instead of the Si substrate. Reference numerals 1221, 1222, 1223, 1224 and 1225 shown in FIG. 15 respectively indicate a GaAs layer of the first conductivity type, a Al_{z}Ga_{1-z}As layer of the first conductivity type, a Al_{y}Ga_{1-y}As layer of the first conductivity type, a AlₓGa₁₋ₓAs layer of the second conductivity type, and a GaAs layer of the second conductivity type.

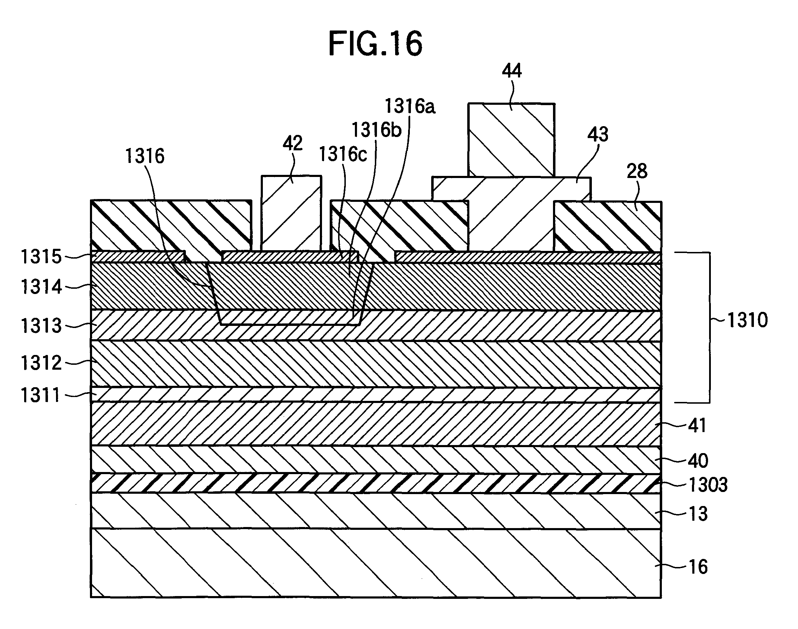

FIG. 16 is a sectional view showing a fourth modification of the light-emitting portion of the semiconductor device of Embodiment 1. In the modification shown in FIG. 16, the light-emitting portion 1316 is formed by diffusing impurities of the second conductivity type into the layered structure of the semiconductor layers of the first conductivity type. Reference numerals 1311, 1312, 1313, 1314 and 1315 respectively indicate semiconductor layers of the first conductivity type, to be more specific, a GaAs layer, an Al_{z}Ga_{1-z}As layer, an Al_{y}Ga_{1-y} As layer, an AlₓGa₁₋ₓAs layer and a GaAs layer. Reference numerals 1316a, 1316b and 1316c indicate diffusion regions constituting the light emitting portion 1316. A reference numeral 16 indicates a GaAs substrate.

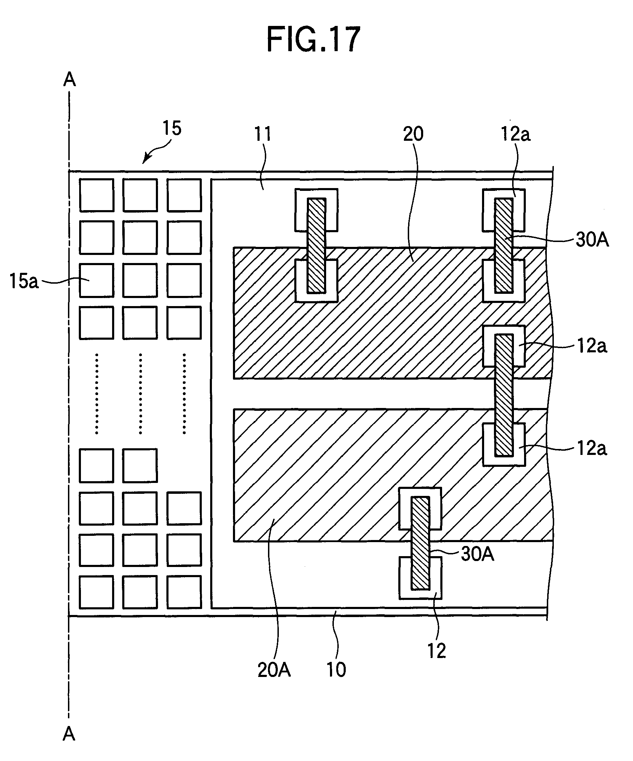

FIG. 17 is a plan view showing another modification of Embodiment 1. In the modification shown in FIG. 17, another semiconductor thin film 20A is formed on the base insulating layer 11 of the semiconductor substrate 10, in addition to the semiconductor thin film 20. The separate pattern portion 15 having a plurality of separate pattern segments 15a is formed on the end portion of the semiconductor substrate 10. In FIG. 17, reference numerals 12a indicate connection pads, and reference numerals 30A indicate interconnection lines.

### Embodiment 2.

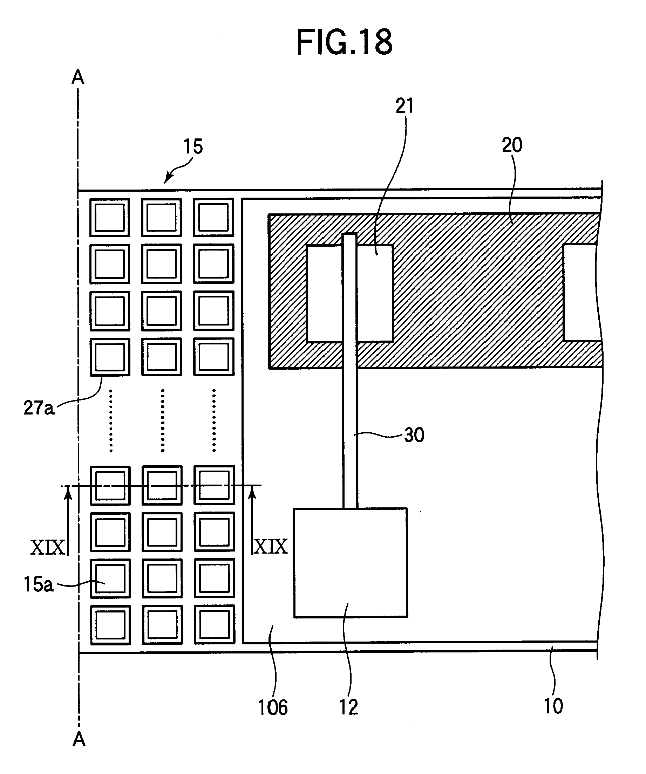

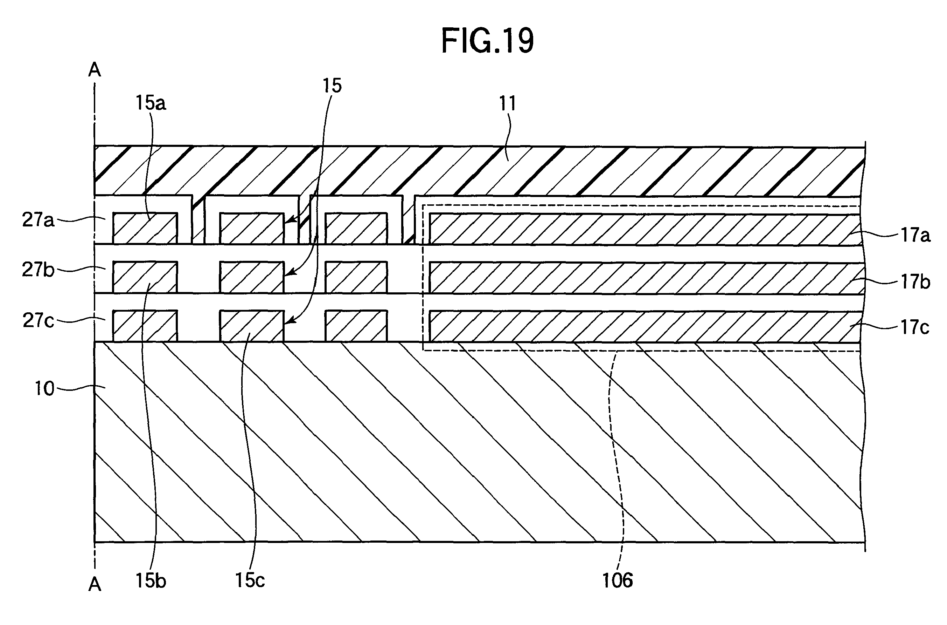

FIG. 18 is a plan view showing a semiconductor device according to Embodiment 2 of the present invention. FIG. 18 illustrates a configuration in which separate pattern segments of the separate pattern portion are covered by separated interlayer insulating films. FIG. 19 is a sectional view of the semiconductor device of Embodiment 2, taken along line XIX-XIX shown in FIG. 18.

In FIG. 19, a reference numeral 10 indicates a Si substrate. Reference numerals 17a, 17b and 17c indicate respective metal layers of the first, second and third interconnection layers. Reference numerals 27a, 27b and 27c indicate respective interlayer insulating layers of the first, second and third interconnection layers. Reference numerals 15a, 15b and 15c indicate separate pattern segments of the separate pattern portion 15 provided corresponding to the first, second and third interconnection layers. The separate pattern segments 15a, 15b and 15c are respectively covered by the interlayer insulating layers 27a, 27b and 27c. A base insulating layer 11 is formed on the top of the interlayer insulating layer 27a. The base insulating layer 11 is formed on, at least, a region onto which the semiconductor thin film 20 is bonded.

In FIG. 19, the base insulating layer 11 is illustrated to reach the position of the dicing line A-A. However, it is also possible that the end portion of the base insulating layer 11 does not reach the dicing line A-A. As long as the base insulating layer 11 exists, at least, below the region onto which the semiconductor thin film 20 is bonded, it is possible to provide the base insulating layer 11 over the entire chip or on a part of the chip. The materials of the separate pattern segments 15a, 15b and 15c, the insulating film 28 (covering the semiconductor thin film 20) and the base insulating layer 11 can be the same as those described in Embodiment 1. The composition of the semiconductor thin film 20 is the same as that described in Embodiment 1. The materials of the metal layers 17a, 17b and 17c of the interconnection layers of the integrated circuit region 106 can be the same as, or can be different from the material of the separate pattern segments 15a, 15b and 15c. The separate pattern portions 15 are formed on the end portion of the semiconductor substrate 10, and include a plurality of separate pattern segments 15a, 15b and 15c formed on the respective layers. In each of the separate pattern portions 15 of the lower two layers (i.e., layers except an uppermost layer), the separate pattern segments 15b (15c) are integrally covered by the interlayer insulating layer 27. However, in the separate pattern portion 15 of the uppermost layer, the separate pattern segments 15a are individually covered by the separated interlayer insulating layers 27a.

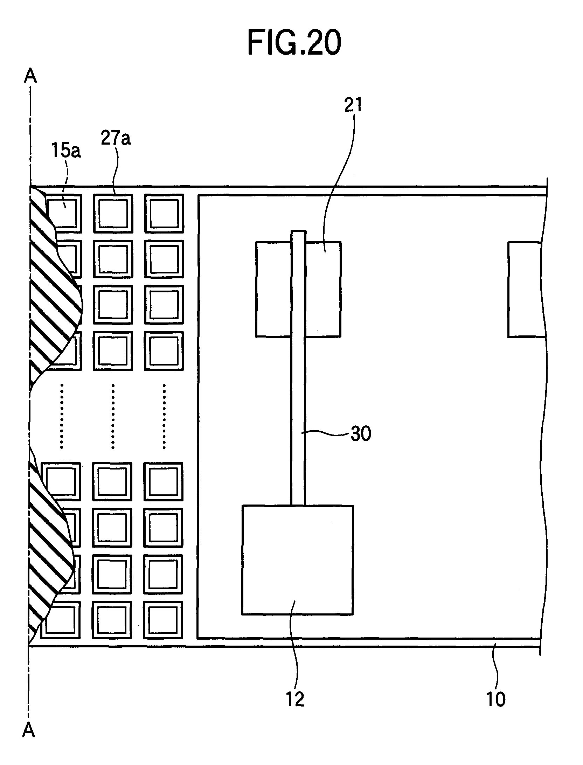

FIG. 20 is a plan view showing a fracture that occurs in the dicing process of the semiconductor device according to Embodiment 2. When the dicing is performed along the dicing line A-A shown in FIG. 20, an external force is applied by the dicing saw to the separate pattern segments 15a (15b, 15c) on the outermost column and parts of the interlayer insulating layer 27 formed thereon, and therefore the separate pattern segments 15a (15b, 15c) and the parts of the interlayer insulating layer 27a (27b, 27c) formed thereon may be peeled off from the semiconductor substrate 10. In this Embodiment 2, the separate pattern segments 15a of the uppermost layer are independently covered by the interlayer insulating layer 27a, and therefore the external force is not transmitted to the adjacent inner separate pattern segments 15a via the interlayer insulating layer 27a. Therefore, it becomes possible to more effectively prevent the spread of the peeling (of the interlayer insulating layer or the metal film) to the inner region.

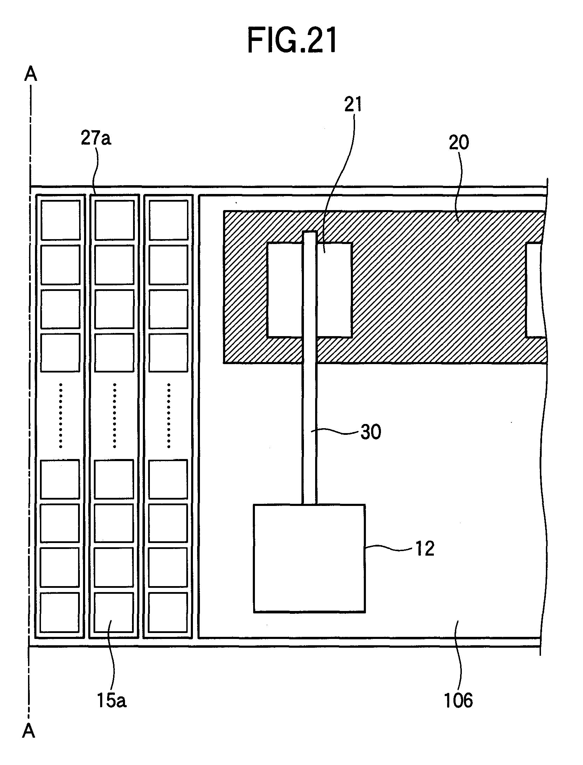

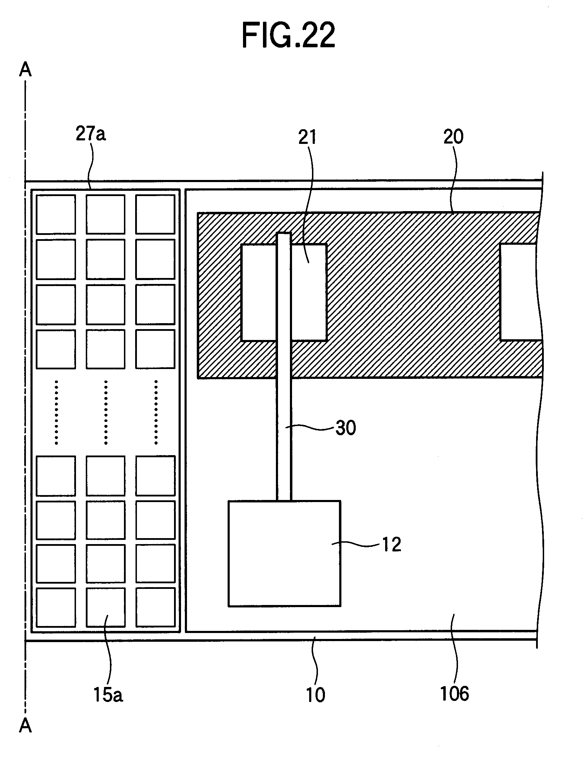

FIG. 21 is a plan view showing a first modification of Embodiment 2. FIG. 22 is a plan view showing a second modification of Embodiment 2.

In the modification shown in FIG. 21, the interlayer insulating layers 27a covering the separate pattern segments 15a of the uppermost layer are separated only in the X-direction (perpendicular to the dicing line A-A), and integrated in the Y-direction. In the modification shown in FIG. 22, the interlayer insulating layer 27a covering the separate pattern segments 15a of the uppermost layer are integrated with each other, but separated only from the interlayer insulating layer of the integrated circuit region 106. The interlayer insulating layers 27a can be modified to have various types of patterns other than those shown in FIGS. 21 and 22.

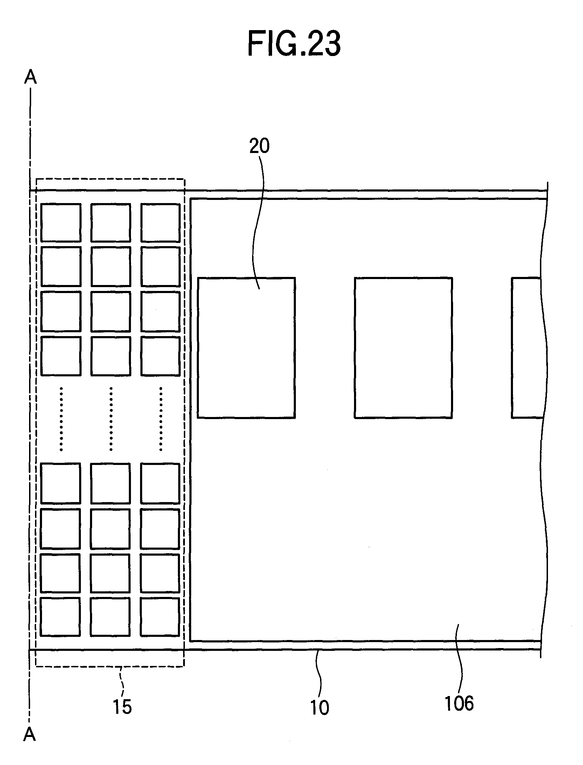

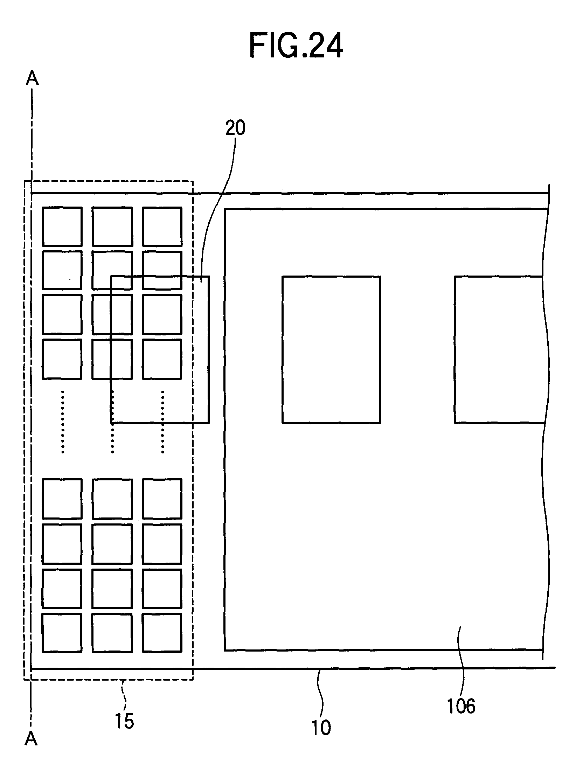

FIG. 23 is a plan view showing a third modification of Embodiment 2. FIG. 24 is a plan view showing a fourth modification of Embodiment 2. In FIGS. 23 and 24, the light-emitting portion and the interconnection line leading to the integrated circuit region 106 are omitted.

The semiconductor device of the modification shown in FIG. 23 includes a plurality of independent semiconductor thin films 20 (each having an individual element) provided separately from each other. The semiconductor device of the modification shown in FIG. 24 includes a plurality of semiconductor thin films 20 provided separately from each other, and at least one of the semiconductor thin films 20 is disposed on the separate pattern region 15.

In the above described first and second embodiments and modifications thereof, the semiconductor substrate 10 or 10A can be formed of a glass plate or an oxide plate. In such a case, the integrated circuit can be formed on the substrate using poly-crystal silicon as base material.

### Embodiment 3.

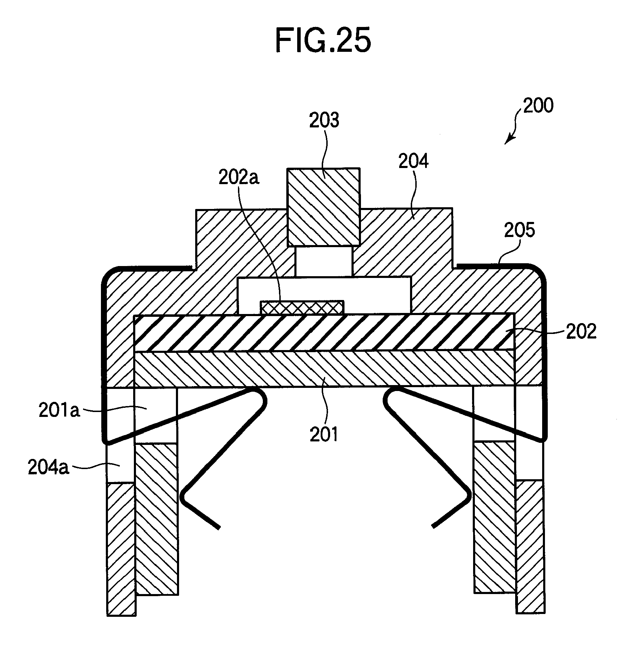

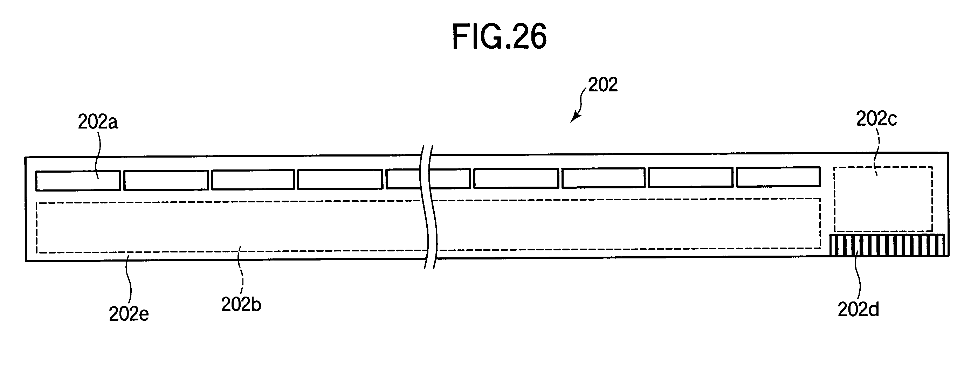

FIG. 25 is a sectional view showing an embodiment of an LED print head according to the LED head of the present invention. FIG. 26 is a plan view showing a configuration example of the LED head.

As shown in FIG. 25, an LED print head 200 includes an LED unit 202 mounted on a base member 201. The LED unit 202 includes the semiconductor device according to Embodiment 1 or 2 mounted on a mounting board 202e (FIG. 26). As shown in FIG. 26, a plurality of the semiconductor devices (each of which includes the light-emitting portion and the driving portion as described in the previous embodiments) are arranged on the mounting board 202e in the longitudinal direction of the mounting board 202e, and constitute light-emitting units 202a. Additionally, electric components mounting regions 202b and 202c (on which electric components are mounted and interconnection lines are formed), a connector 202d for receiving control signal and electric power from outside, and the like are provided on the mounting board 202e.

As shown in FIG. 25, a rod lens array (as optical elements) 203 is provided on the light-emitting portions of the light-emitting units 202a, and collect the lights emitted from the light emitted portions. The rod lens array 203 includes a plurality of columnar optical elements arranged along the linearly arranged light-emitting portions of the light emitting units 202a, and are supported at predetermined positions by a lens holder (as an optical element holder) 204.

The lens holder 204 is formed to cover the base member 201 and the LED unit 202 as shown in FIG. 25. The base member 201, the LED unit 202 and the lens holder 204 are integrally clamped by a clamper 205 via openings 201a and 204a formed on the base member 201 and the lens holder 204. With such an arrangement, the lights emitted by the LED units 202 irradiate predetermined members provided outside, via the rod lens array 203. The LED print head 200 is used as, for example, an exposing device of an electrophotographic printer or an electrophotographic copier or the like.

As described above, according to the LED head (i.e., the LED print head 200) of Embodiment 3, the semiconductor device according to Embodiment 1 or 2 is employed as the LED unit 202, and therefore it becomes possible to obtain the LED head having high quality and high reliability.

### Embodiment 4.

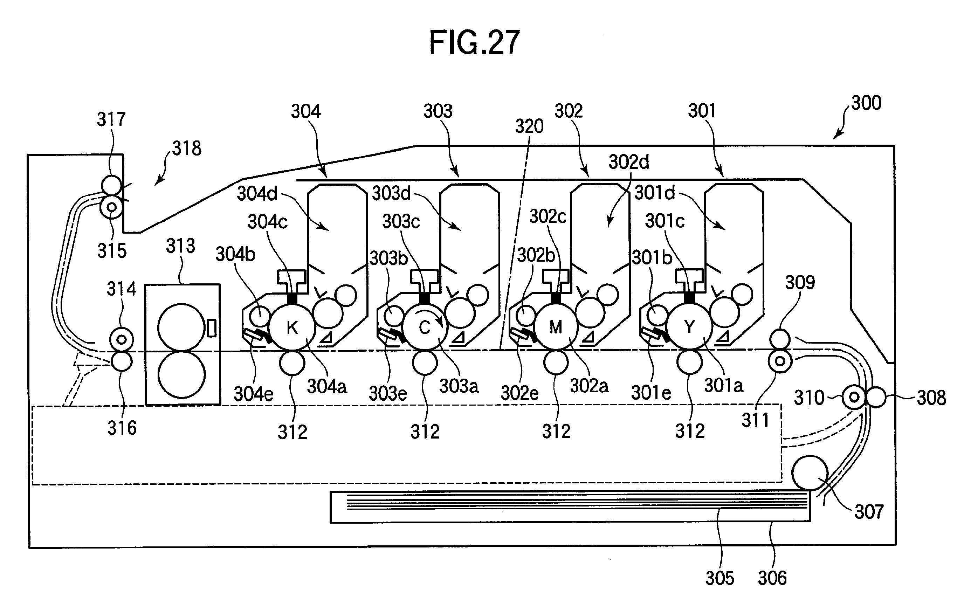

FIG. 27 is a view showing a configuration of a main part of an image forming apparatus according to Embodiment 4 of the present invention.

As shown in FIG. 27, an image forming apparatus 300 of Embodiment 4 includes four process units 301, 302, 303 and 304 that respectively form images of yellow, magenta, cyan and black. The process units 301, 302, 303 and 304 are arranged along a feeding path 320 of a recording medium 305 in this order from the upstream to the downstream. The process units 301, 302, 303 and 304 have common internal structures, and therefore the internal structure of the cyan process unit 303 will be described as an example of the process units 301 through 304.

The process unit 303 includes a photosensitive drum 303a as an image bearing body rotatable in the direction shown by an arrow. The process unit 303 further includes a charging device 303b, an exposing device 303c, a developing device 303d and a cleaning device 303e disposed along the circumference of the photosensitive body 303a in this order from the upstream to the downstream of the rotational direction of the photosensitive drum 303a. The charging device 303b uniformly charges the surface of the photosensitive drum 303a. The exposing device 303c selectively exposes the charged surface of the photosensitive drum 303a with light to form a latent image. The developing device 303d supplies the toner of the predetermined color (cyan) to the surface of the photosensitive drum 303a on which the latent image is formed, to thereby develop the latent image. The cleaning device 303e removes the toner that remains on the surface of the photosensitive drum 303a. The drums and rollers of the respective devices are driven by not shown driving sources and not shown gears.

A detachable sheet cassette 306 is mounted to the lower part of the image forming apparatus 300. The sheet cassette 306 stores a stack of the recording media 305. A hopping roller 307 is disposed above the sheet cassette 306, for feeding the recording medium 305 one by one. A pair of a registration roller 310 and a pinch roller 308, and another pair of a registration roller 311 and a pinch roller 309 are disposed on the downstream side of the hopping roller 307 in the feeding direction of the recording medium 305. The pair of the registration roller 310 and the pinch roller 308 and the pair of the registration roller 311 and the pinch roller 309 respectively nip the recording medium 305 to correct the skew of the recording medium 305 and feed the recording medium 305 to the process units 301 through 304. The hopping roller 307 and the registration rollers 310 and 311 are driven in synchronization with each other by not shown driving sources and not shown gears.

Transfer rollers 312 are disposed in opposition to the respective photosensitive drums 301a through 304a of the process units 301 through 304. The transfer rollers 312 are made of semiconductor rubber or the like. In order to transfer the toner from the photosensitive drums 301a through 304a to the recording medium 305, predetermined electric potentials are applied between the surfaces of the photosensitive drums 301a through 304a and the surfaces of the respective transfer rollers 312.

A fixing device 313 includes a heating roller and a backup roller, and applies heat and pressure to the toner having been transferred to the recording medium 305, so as to fix the toner to the recording medium 305. A pair of an ejection roller 314 and a pinch roller 316, and another pair of an ejection roller 315 and a pinch roller 317 respectively nip the recording medium 305 fed out of the fixing device 313, and feed the recording medium 305 to a stacker portion 318. The ejection rollers 314 and 315 are driven in synchronization with each other by not shown driving sources and gears. Further, the LED print head 200 having been described in Embodiment 3 is used as the exposing device 303c.

Next, the operation of the image forming apparatus will be described.

The recording medium 305 of the stack stored in the sheet cassette 306 is fed out of the sheet cassette 306 by the hopping roller 307 one by one, starting from the uppermost recording medium 305. Then, the recording medium 305 is nipped by the pair of the registration roller 310 and the pinch roller 308 and by the pair of the registration roller 311 and the pinch roller 309, and reaches the photosensitive drum 301a and the transfer roller 312 of the process unit 301. Then, the recording medium 305 is nipped by the photosensitive drum 301a and the transfer roller 312 so that the toner image is formed on the surface of the recording medium 305, and the recording medium 305 is fed by the rotation of the photosensitive drum 301a.

Similarly, the recording medium 305 passes the process units 302, 303 and 304 in this order. In this process, the latent images formed by the exposing devices 301c through 304c are developed by the developing device 301d through 304d, and the toner images of the respective colors are transferred to the recording medium 305 in an overlapping manner. Then, the recording medium 305 is fed to the fixing device 313 where the toner image is fixed to the recording medium 305. Further, the recording medium 305 is nipped by the pair of the ejection roller 314 and the pinch roller 316 and the pair of the ejection roller 315 and the pinch roller 317, and ejected to the stacker portion 318 outside the image forming apparatus 300. With the above described process, the color image is formed on the recording medium 305.

As described above, the image forming apparatus of Embodiment 4 employs the LED print head described in Embodiment 3, and therefore it becomes possible to provide an image forming apparatus having high quality and high reliability.

In this regard, in the above described Embodiments 1 and 2, the semiconductor element formed in the semiconductor thin film of the semiconductor device takes the form of the light emitting element (LED). However, the semiconductor element is not limited to the light-emitting element, but the present invention is also applicable to various embodiments. For example, the present invention is applicable to an embodiment where the light receiving element is formed instead of the light-emitting element, or an embodiment where a semiconductor element other than these optical elements is formed.

### Embodiment 5.

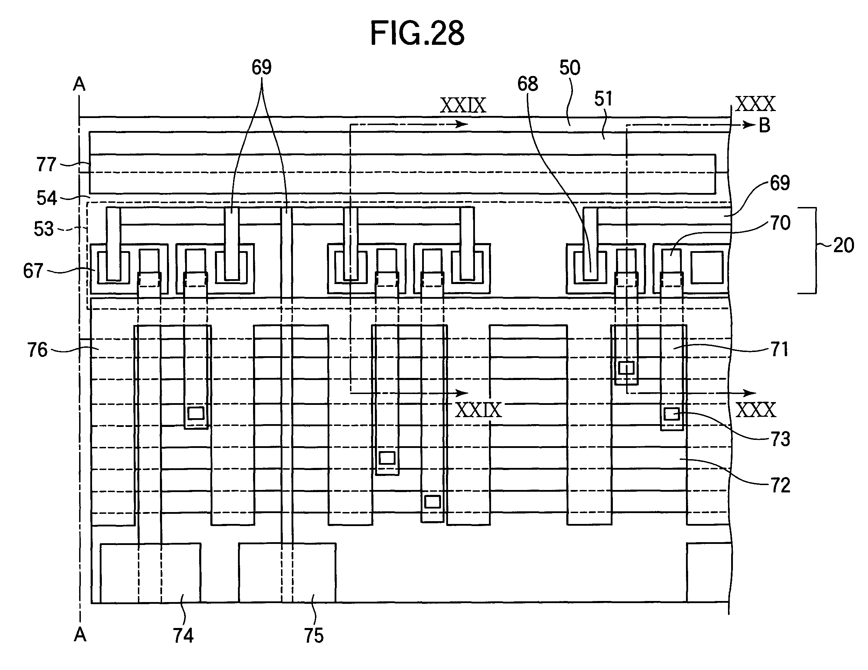

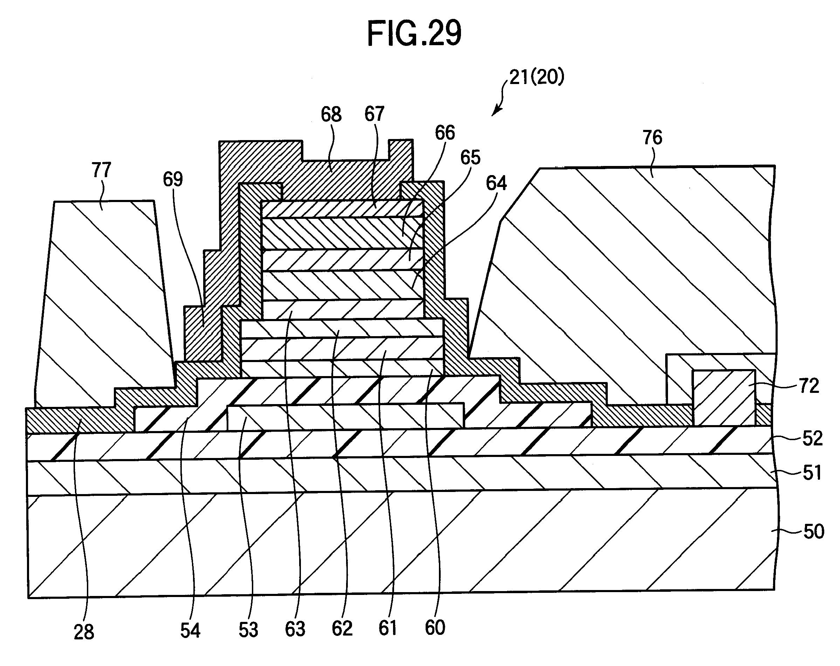

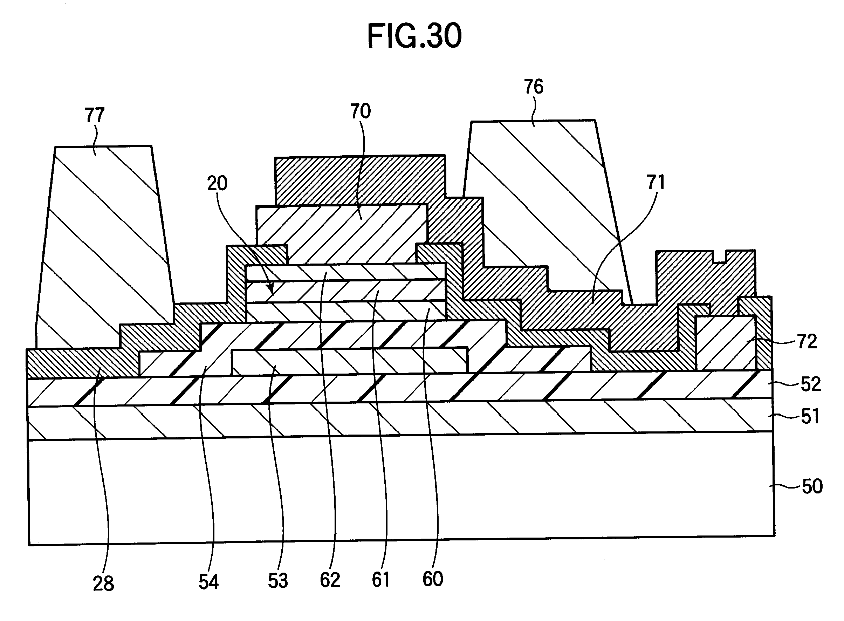

FIG. 28 is a plan view showing a semiconductor device according to Embodiment 5 of the present invention. FIG. 29 is a sectional view of the semiconductor device, taken along line XXIX-XXIX shown in FIG. 28. FIG. 30 is a sectional view of the semiconductor device, taken along line XXX-XXX shown in FIG. 28.

The semiconductor device includes a Si substrate 50, an interconnection layer 51 of an integrated circuit formed on the Si substrate 50, and an insulating layer 52 formed on the interconnection layer 51. A metal layer 53 as a reflection layer is formed on the insulating layer 52 in a region where a semiconductor element is to be formed. An insulating layer 54 is formed on the metal layer 53.

A semiconductor thin film 20 is formed on the insulating layer 54. The semiconductor thin film 20 is formed of semiconductor epitaxial layers constituting a thin film light-emitting diode as shown in FIG. 29. The semiconductor thin film 20 includes a GaAs layer 60 of the first conductivity type, an AlₜGa₁₋ₜ As layer 61 of the first conductivity type formed on the GaAs layer 60, a contact layer 62 of GaAs of the first conductivity type formed on the AlₜGa₁₋ₜ As layer 61, an etching stopper layer 63 of InₛGa₁₋ₛP formed on the contact layer 62, a lower cladding layer 64 of AlₓGa₁₋ₓAs of the second conductivity type formed on the etching stopper layer 63, an active layer 65 of Al_{y}Ga_{1-y}As of the second conductivity type formed on the lower cladding layer 64, an upper cladding layer 66 of Al_{z}Ga_{1-z}As of the second conductivity type formed on the active layer 65, and a contact layer 67 of GaAs of the second conductivity type formed on the upper cladding layer 66. In this regard, the suffixes satisfy the relationship: z, x, t > y. The suffix s is set in the range from 0.49 to 0.52.

An electrode 68 is formed on the contact layer 67 of the semiconductor thin film 20. An end of an interconnection line 69 of the second conductivity side is connected to the electrode 68 via an insulating film 28 covering the semiconductor thin film 20. On the first conductivity side of the semiconductor thin film 20, an electrode 70 is formed on the contact layer 62, and an end of an interconnection line 71 of the first conductivity side is connected to the electrode 70 via the insulating film 28, as shown in FIG. 30.

In FIG. 30, a reference numeral 72 indicates a common interconnection line, and a reference numeral 73 indicates a contact portion between the common interconnection line 72 and the interconnection line 71 of the first conductivity side. Further, in FIG. 28, a reference numeral 74 indicates a connection pad of the first conductivity side, and a reference numeral 75 indicates a connection pad of the second conductivity side. The connection pads 74 and 75 are connected to a not shown driving circuit.

The above described electrode 68 and the interconnection line 69 are preferably made of metal including Au (such as Ti/Pt/Au, Ni/Au or the like), or metal including Al (such as Al, Ni/Al or the like). The above described electrode 70 is preferably made of AuGe/Ni/Au, AuGeNi/Au or the like. The above described insulating film 28 is formed of either of SiN, SiO₂, SiON, PSG, Al₂O₃ and AlN, or organic material.

The semiconductor device of Embodiment 5 has a light shielding layer 76 of a comb-shape (see FIG. 28) formed on a surface thereof. The light shielding layer 76 is provided for preventing the light emitted by the light-emitting portion 21 of the semiconductor thin film 20 from being reflected by a wire (not shown) for the connection with the outside circuit. The light shielding layer 76 is formed of an organic coated film such as polyimide, a permanent resist or the like.

Further, the semiconductor device of Embodiment 5 has a peeling-preventing pattern portion 77 on the end portion of the insulating layer 54 side, and the peeling-preventing pattern portion 77 extends in the longitudinal direction (i.e., the X-direction) of the semiconductor substrate 50. The peeling-preventing pattern portion 77 has an elongated shape so that the peeling-preventing pattern portion 77 holds the end of the insulating layer 54 extending in the longitudinal direction (of the semiconductor substrate 50) via the insulating film 28. The peeling-preventing pattern portion 77 is made of the same material as the light shielding layer 76.

Therefore, while the dicing is performed along the dicing line A-A so that the external force is applied by the dicing saw to the end portions of the insulating film 28 and the insulating layer 54, even when the end portions of the insulating film 28 and the insulating layer 54 are peeled off, the peeling does not spread beyond the peeling-preventing pattern portion 77, since the end portions of the insulating film 28 and the insulating layer 54 are held (i.e., urged against the semiconductor substrate 50) by the peeling-preventing pattern portion 77. Therefore, the insulating layer 54 and the insulating film 28 are not peeled or fractured. As a result, the peeling of the semiconductor thin film 20 can be prevented.

The thickness of the peeling-preventing pattern portion 77 is preferably in the range from 0.5 µm to 10 µm. Particularly, in the case where the peeling-preventing pattern portion 77 is formed of organic material, the action of holding becomes small when the thickness is thinner than 0.5 µm, and the formation of the peeling-preventing pattern portion 77 becomes difficult when the thickness is thicker than 10 µm.

As described above, according to Embodiment 5, the peeling-preventing pattern portion 77 is provided to hold the end portion of the base insulating layer 54 at the end portion of the semiconductor substrate 50, and therefore it becomes possible to prevent the base insulating layer 54 from being peeled off from the semiconductor substrate 50.

In Embodiment 5, it is also possible to omit the shielding layer 76, in the case where the distance from the light-emitting portion 21 to the connection pads 74 and 75 can be lengthened.

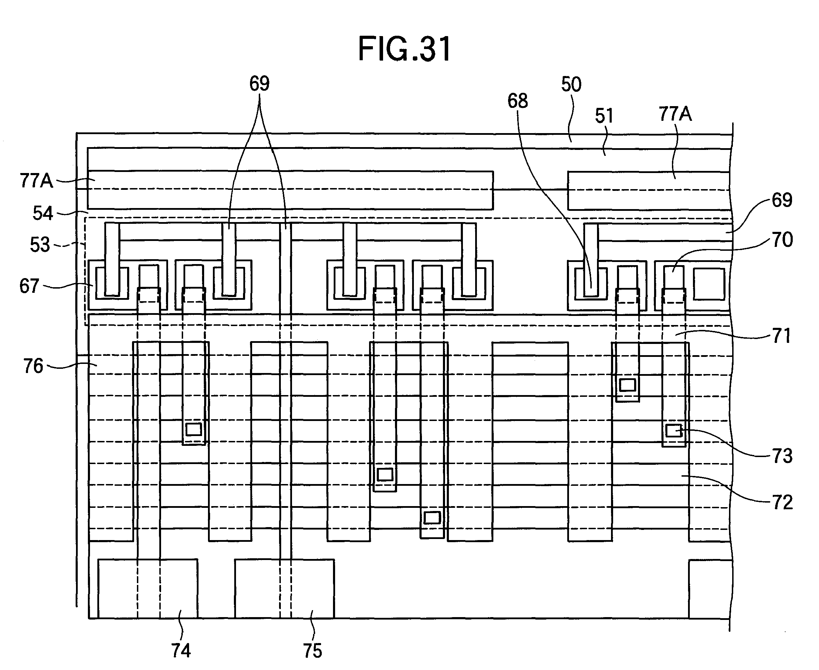

FIG. 31 is a plan view showing a first modification of Embodiment 5.

In the modification shown in FIG. 31, a plurality of separated peeling-preventing pattern portions 77A are provided. The other configuration is the same as Embodiment 5.

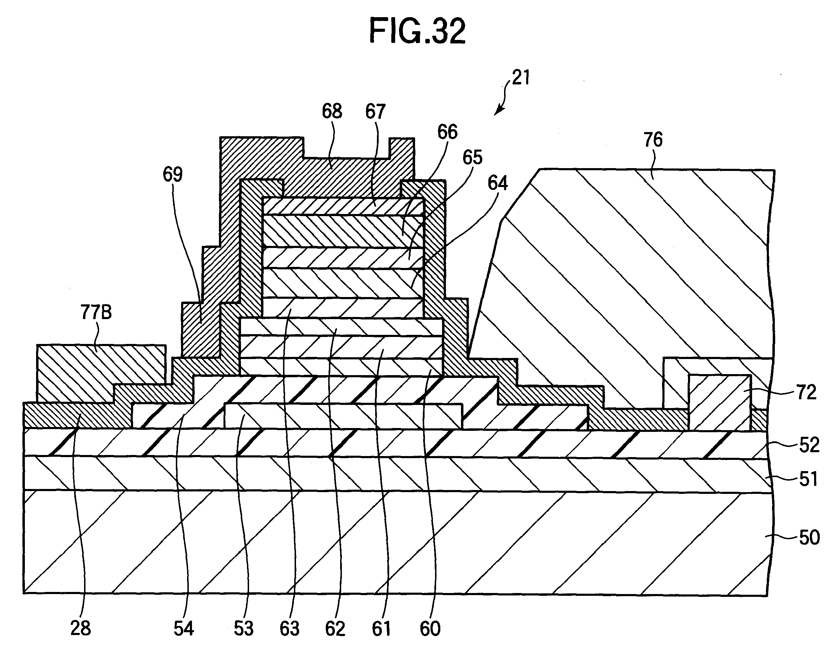

FIG. 32 is a plan view showing a second modification of Embodiment 5.

In the modification shown in FIG. 32, the peeling-preventing pattern portion 77B is made of metal material. As the metal material, it is possible to use, for example, metal including Au (such as Ti/Pt/Au, Ni/Au or the like), or metal including A1 (such as Ni/Al, Al or the like).

When the peeling-preventing pattern portion 77B is made of metal material, the thickness of the peeling-preventing pattern portion 77B is preferably in the range from 0.5 µm to 2 µm. When the thickness is thinner than 0.5 µm, the the peeling-preventing pattern portion 77B itself does not have sufficient coating properties, and therefore it is difficult to obtain the sufficient holding force (for holding the end portions of the insulating film 28 and the insulating layer 54). When the thickness is thicker than 2 µm, the there is a possibility that the peeling-preventing pattern portion 77B may apply a force to elements constituting the integrated circuit, and the formation of the peeling-preventing pattern portion 77B may become difficult.

When the peeling-preventing pattern portion 77B is formed of metal material as in this modification, the contact between the insulating film 28 and the peeling-preventing pattern portion 77B can be enhanced, and therefore it becomes possible to effectively prevent the peeling of the insulating film 28 and the insulating layer 54. Moreover, the thickness of the peeling-preventing pattern portion 77B can be thinner than the peeling-preventing pattern portion 77 made of organic material, and therefore a high (thick) portion at the end portion of the semiconductor device (chip) can be eliminated. As a result, the possibility of abutting of a collet used for mounting the semiconductor device against the peeling-preventing pattern portion 77B can be reduced, and therefore the handling of the semiconductor device becomes easy. Further, since the peeling-preventing pattern portion 77B can be thinned, the peeling-preventing pattern portion 77B can be widely applied.

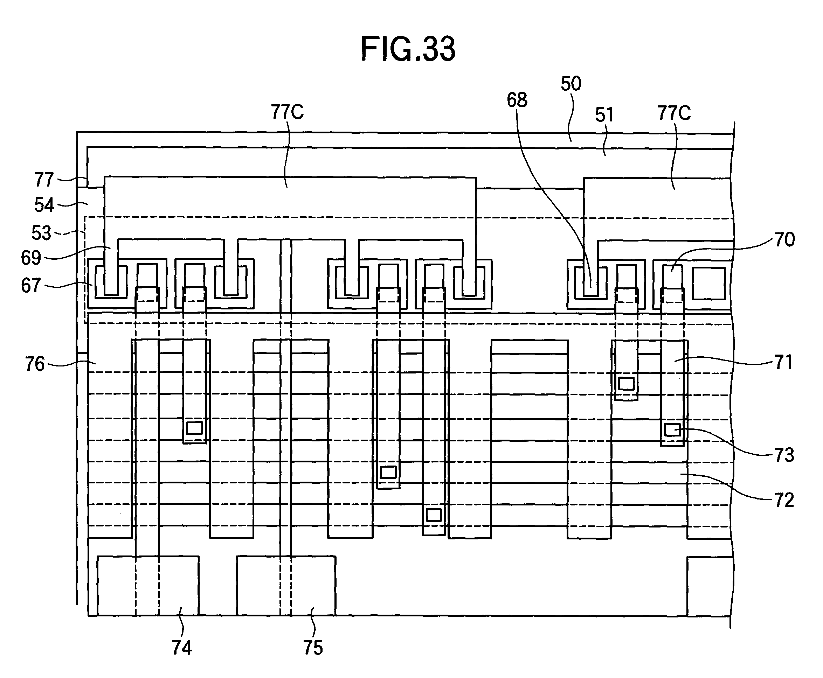

FIG. 33 is a plan view showing a third modification of Embodiment 5.

In the modification shown in FIG. 33, a plurality of separated peeling-preventing pattern portions 77C (made of metal material) are provided integrally with the interconnection lines 69 of the second conductivity side. The peeling-preventing pattern portions 77C hold the insulating layer 54 to prevent the peeling of the insulating layer 54 on the dicing.

In the description of Embodiment 5 and the modifications, the peeling-preventing pattern portion has been described to be made of organic film or metal material, but the organic film can be replaced with inorganic film such as SOC. Further, the peeling-preventing pattern portion can take the form of a layered structure formed by layering organic film or inorganic film formed on the metal layer.

The semiconductor device of Embodiment 5 and the modifications thereof are applicable to the LED head (FIGS. 25, 26) of Embodiment 3 and applicable to the image forming apparatus (FIG. 27) of Embodiment 4.

While the preferred embodiments of the present invention have been illustrated in detail, it should be apparent that modifications and improvements may be made to the invention without departing from the spirit and scope of the invention as described in the following claims.

## Claims

1. A semiconductor device manufactured using dicing of a semiconductor wafer, said semiconductor device comprising:
a substrate (10);
a base insulating layer (11) formed on said substrate (10);
a semiconductor element (21) formed on said base insulating layer (11), and
a separate pattern portion (15) formed on an end portion of said substrate (10) separately from said base insulating layer (11),
wherein said separate pattern portion (15) prevents said base insulating layer (11) from being peeled off from said substrate (10) when said dicing is performed.

2. The semiconductor device as set forth in claim 1, wherein said semiconductor element (21) is formed in a semiconductor thin film (20), and said semiconductor thin film (20) is bonded onto said base insulating layer (11).

3. The semiconductor device as set forth in claim 1 or 2, wherein said separate pattern portion (15) includes a plurality of pattern segments (15a) arranged in at least one column along an end portion of said substrate (10).

4. The semiconductor device as set forth in any of claims 1 to 3, wherein said separate pattern portion (15) is made of metal material or insulating material.

5. A semiconductor device manufactured using dicing of a semiconductor wafer, said semiconductor device comprising:
a substrate (50);
a base insulating layer (52) formed on said substrate (50);
a semiconductor element (21) formed on said base insulating layer (52), and
a peeling-preventing pattern portion (77) that holds an end portion of said base insulating layer (52) at an end portion of said substrate (50).

6. The semiconductor device as set forth in claim 5, wherein said peeling-preventing pattern portion (77) is formed of metal material, organic material or inorganic material.

7. An LED head comprising:
a plurality of said semiconductor devices as set forth in any of claims 1 to 6, said semiconductor devices constituting LEDs (202);
a supporting body (201) that supporting said semiconductor devices, and
a lens array (203) that collects emitted lights from said semiconductor devices.

8. An image forming apparatus comprising:
said LED head (200, 301c, 302c, 303c, 304c) as set forth in claim 7;
a photosensitive body (301a, 302a, 303a, 304a) exposed by said LED head (200) so that a latent image is formed thereon, and
a developing device (301d, 302d, 303d, 304d) that develops said latent image.

9. A semiconductor device comprising:
a substrate (50);
a base insulating layer (52) formed on said substrate (50); and
a semiconductor element (21) formed on said base insulating layer (52);
**characterised by**:
a pattern portion (77) formed on the substrate (50), configured to retain a portion of the base insulating layer (52) on said substrate (50).

10. A method of manufacturing a plurality of semiconductor devices, comprising:
forming a base insulating layer (52) on a substrate (50);
providing a plurality of semiconductor elements (21) on said base insulating layer (52); and
dicing said substrate at a plurality of cutting positions;
**characterised by**:
forming pattern portions (77) on the substrate (50) at positions adjacent to said plurality of cutting positions, the pattern portions (77) being configured to retain respective portions of the base insulating layer (52) on said substrate (50).
